# EUROPÄISCHE PATENTSCHRIFT

(11) **EP 3 541 650 B1**
(45) Veröffentlichungstag und Bekanntmachung des Hinweises auf die Patenterteilung: **23.12.2020**
(21) Anmeldenummer: 17801038.5
(22) Anmeldetag: 18.11.2017
(51) Int. Cl.: B60L 3/00, H03K 17/30, H02M 3/158, B60L 58/20

(54) **HYBRIDES ENERGIESPEICHERSYSTEM**
HYBRID ENERGY STORAGE SYSTEM
SYSTÈME DE STOCKAGE D'ÉNERGIE HYBRIDE

(30) Priorität: 21.11.2016 DE 102016122383
(43) Veröffentlichungstag der Anmeldung: 25.09.2019
(73) Patentinhaber: Rutronik Elektronische Bauelemente GmbH, 75228 Ispringen (DE)
(72) Erfinder: LEHMANN, Ringo, 08066 Zwckau (DE); ZACHARIAS, Lutz, 09405 Gornau/Erzgebirge (DE); BODACH, Mirko, 09353 Oberlungwitz (DE); SLAWINSKI, Sven, 08209 Auerbach/Vogtland (DE); MANGLER, Andreas, 76228 Karlsruhe (DE); KRIEG, Markus, 75228 Ispringen (DE)
(74) Vertreter: RPK Patentanwälte Reinhardt, Pohlmann und Kaufmann Partnerschaft mbB
(86) Internationale Anmeldenummer: PCT/EP2017/079696
(87) Internationale Veröffentlichungsnummer: WO 2018/091697

(56) Entgegenhaltungen:
- EP-A2- 0 744 817
- US-A1- 2011 032 733
- US-A1- 2011 272 205
- KIM JONG-SEOK ET AL: "High-efficiency peak-current-control non-inverting buck-boost converter using mode selection for single Ni-MH cell battery operation", ANALOG INTEGRATED CIRCUITS AND SIGNAL PROCESSING, SPRINGER NEW YORK LLC, US, Bd. 89, Nr. 2, 4. Juli 2016 (2016-07-04), Seiten 297-306, XP036067634, ISSN: 0925-1030, DOI: 10.1007/S10470-016-0787-0 [gefunden am 2016-07-04]

## Beschreibung

### Gebiet der Erfindung

Die Erfindung betrifft ein hybrides Energiespeichersystem zum Austausch von Energien mithilfe einer beliebigen Kombination verschiedener Energiespeicher nach dem Oberbegriff des Anspruches 1.

### Stand der Technik

Hybride Energiespeicher werden bei einer Vielzahl von Anwendungen verwendet, beispielsweise in der automobilen Anwendung, im Bereich der Industrie, bei unterbrechungsfreien Stromversorgungen (USV), in der Medizintechnik (z.B. Defibrillatoren) und für elektrische Werkzeuge. Diese Anwendungen zeichnen sich dadurch aus, dass unterschiedliche Zustände auftreten, in denen unterschiedliche Energien und/oder Energiemengen benötigt werden. Beispielsweise werden beim Starten einer Bohrmaschine hohe Energien bzw. ein hoher Strom benötigt, wohingegen beim weiteren Betrieb der Bohrmaschine, sobald die Bohrmaschine "einmal angelaufen" ist, bei Nennlast wesentlich geringere Energien bzw. Ströme für den Betrieb benötigt werden. Überdies verursachen dynamische mechanische Belastungen hohe fluktuierende Ströme. Gleiches gilt in ähnlicher Weise für Elektroantriebe, welche z.B. in Elektrofahrzeugen oder Fahrzeugen mit einem hybriden Antriebssystem zum Einsatz kommen. Da jedoch jeder Energiespeicher einen sogenannten Komfortbereich aufweist, in welchem der Energiespeicher ohne Beschädigung betrieben werden kann, kommt es folglich zu Problemen bei wechselnder, unterschiedlicher Energieentnahme. Wird der Energiespeicher außerhalb seines Komfortbereiches betrieben, kann es zur Beschädigung des Energiespeichers bzw. zu einer Degradation und damit langsamen Zerstörung des Energiespeichers kommen, wodurch sich unter anderem die Zyklenfestigkeit des Energiespeichers verschlechtert.

Hybride Energiespeichersysteme, bestehend aus mehreren Energiespeichern, erlauben eine Arbeitsteilung: Während ein Energiespeicher in seinem Komfortbereich konstant Energie für eine kontinuierliche Leistung liefert, übernimmt der andere Energiespeicher kurzzeitige Spitzenenergieströme, sodass jeder der Energiespeicher in seinem Komfortbereich betrieben werden kann und es so zu keiner Beschädigung der Energiespeicher kommt. So lässt sich die Lebensdauer der Energiespeicher sowie deren Zyklenfestigkeit verbessern.

In der DE 10 2012 013 413 A1 ist eine Anordnung elektrochemischer Energiespeicher offenbart, welche einen ersten elektrochemischen Energiespeicher und einen zweiten elektrochemischen Energiespeicher aufweist. Beide Energiespeicher sind derart zusammengeschaltet, dass die Energiespeicher über Energieströme untereinander und mit wenigstens einer externen Energiequelle und/oder mit wenigstens einer externen Energiesenke Energie austauschen können. Weiterhin ist eine Einrichtung zur Steuerung der Energieströme vorgesehen, sodass eine Schädigung oder Überlastung des ersten Energiespeichers unter Inkaufnahme einer Schädigung des zweiten Energiespeichers vermieden oder gemindert werden kann. Eine Schädigung des einen Energiespeichers wird dabei zwar gemindert, jedoch nur unter Inkaufnahme der Schädigung des anderen Energiespeichers.

In der US 2011/0084648 A1 sind ein hybrides Energiespeichersystem sowie ein Verfahren zum Betrieb eines hybriden Energiespeichersystems offenbart. Das hybride Energiespeichersystem weist einen Ultra-Kondensator, welcher mit einer Gleichstromsammelschiene verbunden ist, sowie eine über einen Schalter mit der Gleichstromsammelschiene verbundene Energiequelle auf. Ultra-Kondensator und Stromquelle sind beide an einen Gleichspannungswandler angeschlossen. Das hybride Energiespeichersystem arbeitet in vier Modi. In einem Niederenergiemodus stellt der Gleichspannungswandler benötigte Energie zur Verfügung, sodass der Ultra-Kondensator auf einem höheren Spannungsniveau als das der Energiequelle gehalten wird. In einem Hochenergiemodus kann die benötigte Energie nicht mehr durch den Gleichspannungswandler zur Verfügung gestellt werden, das Spannungsniveau des Ultra-Kondensators kann nicht aufrechterhalten werden, und die Energiequelle wird über den Schalter mit der Gleichstromsammelschiene verbunden. In einem Spitzenenergiemodus wird der Ultra-Kondensator verwendet, um die Energie der Energiequelle zu erhöhen. In einem kontrollierten Auflademodus wird von der Anwendung erzeugte Energie dazu verwendet, um den Ultra-Kondensator aufzuladen.

Eine Potentialwandlervorrichtung mit einem ersten Speicherkondensator, einem zweiten Speicherkondensator sowie einer Wandlereinrichtung ist in der DE 10 2008 021 875 A1 offenbart. Der erste Speicherkondensator wird mittels einer Energiequelle mit Energie versorgt. Die Wandlereinrichtung ermöglicht eine Energieübertragung vom ersten zum zweiten Speicherkondensator, falls der Potentialverlauf des ersten Kondensators einen ersten Schwellwert erreicht, solange bis der Potentialverlauf des zweiten Kondensators einen zweiten Schwellwert erreicht, der größer ist als der erste Schwellwert. Ferner wird der erste Kondensator in einer Zeitspanne mit Hilfe der Energiequelle aufgeladen, sodass während dieser Zeitspanne aus dem zweiten Kondensator Energie für einen angeschlossenen Verbraucher entnommen werden kann.

In der Druckschrift "T. Nabeshima; T. Sato; K. Nishijima; S. Yoshida: A Novel Control Method of Boost and Buck-Boost Converters with a Hysteretic PWM Controller. In: EPE 2005, Dresden, 2005, Seiten 1-6" ist ein Verfahren für einen Tief-Hochsetzsteller mit Hilfe eines Hysterese-Pulsbreitenmodulations-Reglers offenbart. Mit Hilfe einer RC-Schaltung, die mit einer Hilfswicklung des Induktors verbunden ist, wird eine Dreieckspannung erzeugt, welche mit der Ausgangsspannung des Tief-Hochsetzstellers überlagert und einem Hysterese-Komparator als ein Rückkopplungssignal zugeführt wird. Es ergibt sich so keine stationäre Fehlerspannung am Ausgang und es werden Schwankungen der Eingangsspannung und des Laststroms ausgeglichen.

Aus der US 2009/0317696 A1 ist eine Batterievorrichtung mit einer Lithiumbatterie und einer Bleisäurebatterie bekannt. Eine Kontrollschaltung weist eine Spannungsdetektionseinrichtung sowie eine Spannungshochsetzeinrichtung auf. Die Spannung der Bleisäurebatterie wird automatisch detektiert und als Referenzpunkt verwendet. Im Anschluss wird die Spannung der Lithiumbatterie auf den Referenzpunkt bzw. auf die Spannung der Bleisäurebatterie erhöht. In dieser Offenbarung wird zwar eine Beschädigung der Bleisäurebatterie durch die Unterstützung der Lithiumbatterie vermindert, jedoch geschieht dies auf Kosten der Lithiumbatterie.

In der WO 03/088373 A2 ist eine hybride Batterieanordnung offenbart mit einem Hochleistungsgerät und einer Hochenergiebatterie, wobei mit Hilfe eines Mikroprozessors, je nach Strombedarf der Last, das Hochleistungsgerät und/oder die Hochenergiebatterie über einen Schalter der Last zugeschaltet wird. Als Schalter wird ein Feldeffekttransistor offenbart. Die Hochenergiebatterie ist mittels eines Gleichspannungswandlers während einer Ausschaltzeit in der Lage, das Hochleistungsgerät wiederaufzuladen. Jedoch weist ein Feldeffekttransistor herstellungsbedingt die Eigenschaft einer bidirektionalen Leitfähigkeit auf, sodass ein Hochsetzvorgang nicht stattfinden kann, da nach jedem Schaltvorgang die hochgesetzte Spannung sich durch einen fließenden Rückwärtsstrom vom höheren Potential zum niedrigen Potential wieder abbaut.

Die US2011/272205 A1 und US2011/032733 A1 offenbaren Hybride Energiespeichersystemen mit eine Entkopplungsschaltung.

### Aufgabe der Erfindung

Ausgehend von diesem Stand der Technik liegt der vorliegenden Erfindung die Aufgabe zugrunde, eine Schädigung, vorzeitige Alterung/Degradation und/oder Überlastung eines Energiespeichers infolge hoher Energieströme zu vermeiden bzw. zu vermindern und eine applikationsspezifische Rekuperationsfähigkeit zu ermöglichen.

Dies wird mit einem hybriden Energiespeichersystem gemäß den Merkmalen des Patentanspruchs 1, sowie mit einem Verfahren zur Steuerung wenigstens eines elektrophysikalischen Energiestroms mit den Merkmalen des unabhängigen Anspruches 10 gelöst. Vorteilhafte Weiterbildungen sind Gegenstand der abhängigen Patentansprüche. Die in den Patentansprüchen einzeln aufgeführten Merkmale sind in technologisch sinnvoller Weise miteinander kombinierbar und können durch Erläutern der Sachverhalte aus der Beschreibung durch Details aus den Figuren ergänzt werden, wobei weitere Ausführungsvarianten der Erfindung aufgezeigt werden.

In dieser Anmeldung wird von Energien, Energieströmen und Energiespeichern gesprochen. Hiermit sind elektrophysikalische Energien gemeint, welche beispielsweise durch Spannungen und Ströme hervorgerufen werden. Möglich sind aber auch kapazitive und/oder induktive Energien. Weiterhin sind die Energiespeicher elektrophysikalisch und/oder elektrochemisch arbeitende Energiespeicher.

Unter "Mitkopplungserscheinungen" werden hier hochfrequente Schaltvorgänge verstanden, die bis zur Zerstörung der Entkopplungsschaltung 20 wie z.B. zur Zerstörung des hierzu verwendeten OR-MOSFET führen können.

Das hybride Energiespeichersystem weist wenigstens zwei Energiespeicher, einen ersten elektrophysikalisch arbeitenden Energiespeicher und einen zweiten elektrophysikalisch arbeitenden Energiespeicher mit jeweils einem nominalen Energiestrom auf. Die Energiespeicher tauschen mit Hilfe wenigstens einer Steuerungsschaltung untereinander und/oder mit wenigstens einer externen Energiequelle und/oder externen Energiesenke elektrische Energie mittels elektrophysikalischer Energieströme wenigstens in einer Richtung aus. Die Steuerungsschaltung weist wenigstens einen Hochsetzsteller, der wenigstens einen elektronischen Schalter aufweist, und/oder wenigstens einen Tiefsetzsteller auf, der die Energiesenke im Falle eines benötigten Energiestroms der Energiesenke, welcher höher ist als der nominale Energiestrom des zweiten Energiespeichers, mit einem Energiestrom des ersten Energiespeichers bedient. Der zweite Energiespeicher liefert einen Energiestrom von Null oder einen konstanten Energiestrom, der maximal dem nominalen Energiestrom des zweiten Energiespeichers entspricht. Vorteilhaft für eine Vermeidung bzw. Verminderung einer Schädigung und/oder Überlastung eines Energiespeichers infolge hoher Energieströme weist die Steuerungsschaltung wenigstens eine Entkopplungsschaltung zur Unterdrückung von Mitkopplungserscheinungen des elektronischen Schalters und/oder zur Verriegelung von durch den elektronischen Schalter vom ersten zum zweiten Energiespeicher fließenden Energierückströmen auf.

Die Bezeichnungen erster Energiespeicher und zweiter Energiespeicher sind willkürlich gewählt und stellen keine Einschränkung dar. In der Regel wird als erster Energiespeicher beispielsweise eine Batterie benannt, der dann ein zweiter Energiespeicher, beispielsweise ein Kondensator, z.B. ein Doppelschichtkondensator hinzugeschaltet wird. Andere Gestaltungsformen und Abläufe sind aber ebenso möglich. Zur Erhöhung des Wirkungsgrades und zum Schutz vor thermischer Überlastung weist der Schalter wenigstens einen Transistor, einen MOSFET, z.B. als OR-MOS-Implementation auf.

Vorteilhaft zur Bedienung von Spannungen und/oder Strömen von großen Energiesenken, die größer als die des zweiten Energiespeichers sind, weist der erste Energiespeicher wenigstens die gleiche Nominalspannung und/oder wenigstens den gleichen Nominalstrom wie der zweite Energiespeicher auf, z.B. die doppelte Nominalspannung und/oder den doppelten Nominalstrom.

Für eine vorzugsweise schnelle Verriegelung der Energierückströme weist die Entkopplungsschaltung wenigstens eine digitale und/oder eine analoge Entkopplungsschaltung auf.

Vorteilhaft für eine Unterdrückung von Mitkopplungserscheinungen des Schalters und einer Verriegelung der Energierückströme weist die Entkopplungsschaltung wenigstens eines der folgenden Elemente auf, nämlich wenigstens ein Proportionalglied, und/oder wenigstens ein Integrierglied.

Das Proportionalglied weist vorzugsweise wenigstens einen Widerstand auf, der den Strom in den Komparator begrenzt, um die Funktion des Komparators zu gewährleisten.

Um vorteilhaft Mitkopplungserscheinungen des Schalters zu unterdrücken, weist das Integrierglied wenigstens einen Kondensator auf.

Zur Erhöhung der Betriebssicherheit der Leistungselektronik, weist die Entkopplungsschaltung wenigstens ein UND-Gatter zur Abschaltung des Schalters bei ausgeschaltetem Hochsetzsteller auf.

Die Steuerungsschaltung weist wenigstens eine Messwerterfassung zur Erfassung von Messwerten der Energiespeicher, der Energiequelle und/oder der Energiesenke auf, wodurch vorteilhaft eine Regelung von Strömen und Spannungen ermöglicht wird.

Die Aufgabe wird zudem durch ein Verfahren zur Steuerung wenigstens eines elektrophysikalischen Energiestroms mit den Merkmalen des Anspruches 8 gelöst. Um eine Schädigung der Schaltung und/oder Überlastung eines Energiespeichers infolge hoher Energieströme zu vermeiden bzw. zu vermindern, werden Mitkopplungserscheinungen des Schalters unterdrückt und/oder durch den Schalter vom ersten zum zweiten Energiespeicher fließende Energieströme unterdrückt.

Als Entkopplungsschaltung wird ein MOSFET-Transistor, z.B. als OR-MOS-Implementation verwendet. Der MOSFET wird vorzugsweise zur Erhöhung des Wirkungsgrades und zum Schutz vor thermischer Überlastung verwendet. Dabei wird die immer vorhandene interne parasitäre Diode, bei vorwärts fließendem Strom, durch den MOSFET unterstützend überbrückt und im Sperrfall wirkt nur dessen parasitäre Diode.

Weitere Vorteile ergeben sich aus den Unteransprüchen und der nachfolgenden Beschreibung eines bevorzugten Ausführungsbeispiels.

### Kurzbeschreibung der Figuren

Im Folgenden wird die Erfindung anhand eines in den beigefügten Figuren dargestellten Ausführungsbeispiels näher erläutert. Es zeigen:
- Fig. 1: ein Blockschaltbild eines hybriden Energiespeichersystems mit zwei Energiespeichern, einer Energiesenke und einer Steuerungsschaltung mit der erfindungsgemäßen Entkopplungsschaltung,
- Fig. 2: einen Ausschnitt des elektrischen Schaltplans der Steuerungsschaltung gemäß Figur 1,
- Fig. 3: eine schematische Darstellung eines Ausschnitts des hybriden Energiespeichersystems,
- Fig. 4: eine Ersatzschaltung eines MOSFETs als Schalter.

### Beschreibung bevorzugter Ausführungsbeispiele

Die Erfindung wird jetzt beispielhaft unter Bezug auf die beigefügten Zeichnungen näher erläutert. Allerdings handelt es sich bei den Ausführungsbeispielen nur um Beispiele, die nicht das erfinderische Konzept auf eine bestimmte Anordnung beschränken sollen.

Bevor die Erfindung im Detail beschrieben wird, ist darauf hinzuweisen, dass sie nicht auf die jeweiligen Bauteile der Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht.

In dieser Anmeldung wird von Energien, Energieströmen und Energiespeichern gesprochen. Hiermit sind elektrophysikalische Energien gemeint, welche beispielsweise durch Spannungen und Ströme hervorgerufen werden. Möglich sind aber auch kapazitive und/oder induktive Energien. Weiterhin sind die Energiespeicher elektrophysikalisch und/oder elektrochemisch arbeitende Energiespeicher.

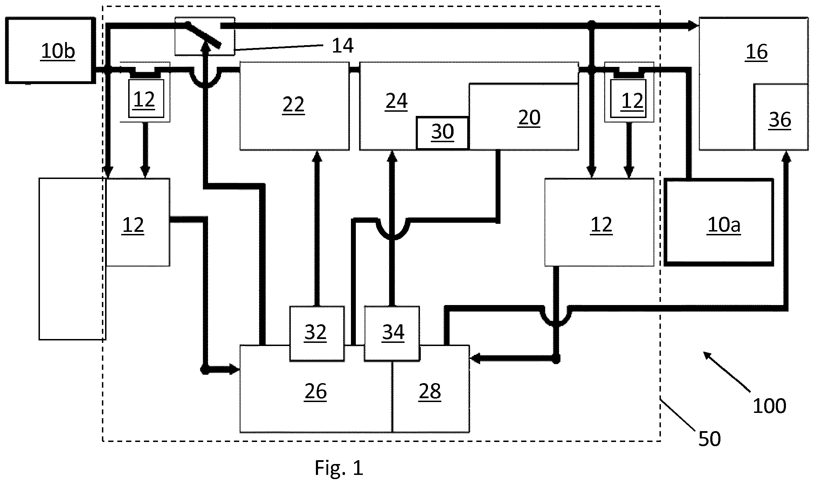

Fig. 1 zeigt ein Blockschaltbild eines hybriden Energiespeichersystems 100 mit zwei Energiespeichern 10a, 10b, nämlich einem ersten Energiespeicher 10a und einem zweiten Energiespeicher 10b mit jeweils einem nominalen Energiestrom, sowie mit einer Energiesenke 16 und einer Steuerungsschaltung 50. Grundsätzlich können auch mehr als zwei Energiespeicher vorgesehen sein. Die Energiespeicher können mit Hilfe der Steuerungsschaltung 50 elektrische Energie über elektrophysikalische/elektrochemische Energieströme wenigstens in einer Richtung untereinander sowie elektrische Energie mit einer externen, von den Energiespeichern bedienbaren Energiesenke 16 austauschen. Wird von der Energiesenke 16 ein höherer Energiestrom als der nominale Energiestrom des zweiten Energiespeichers 10b benötigt, welcher beispielsweise als eine Batterie ausgeführt ist, wird die benötigte Energie mit Hilfe wenigstens eines Hochsetzstellers 24, der wenigstens einen elektronischen Schalter 30 aufweist, und/oder wenigstens eines Tiefsetzstellers 22 von z.B. dem ersten Energiespeicher 10a, welcher beispielsweise als ein Kondensator, z.B. als ein Doppelschichtkondensator ausgeführt ist, zur Verfügung gestellt. Damit sich der erste Energiespeicher 10a nicht noch weiter entladen kann, stellt ein Brückenschalter 14, welcher beispielsweise Halbleiterelemente aufweist, eine direkte energetische Verbindung zwischen dem ersten Energiespeicher 10a und dem zweiten Energiespeicher 10b her. Denkbar ist neben Batterie und Kondensator auch jede andere Ausführung eines elektrophysikalisch und/oder elektrochemisch arbeitenden Energiespeichers.

Der zweite Energiespeicher 10b liefert dadurch einen Energiestrom von null oder einen konstanten Energiestrom, der maximal dem nominalen Energiestrom des zweiten Energiespeichers 10b entspricht. Beispielsweise ist es möglich, mit dem konstanten Energiestrom des zweiten Energiespeichers 10b den ersten Energiespeicher 10a wieder aufzuladen. Zur Regelung des Energiemanagements zwischen den beiden Energiespeichern 10a, 10b weist die Steuerungsschaltung 50 wenigstens einen Mikrokontroller 26, wenigstens einen Digital/Analog Wandler 28, der einen Kontrollschalter 36 der externen Energiesenke 16 schaltet, und jeweils einen Pulsweitenmodulator 32, 34 für den Tiefsetz- 22 und Hochsetzsteller 24 auf. Im Fall einer hohen Dauerbelastung entlädt sich der erste Energiespeicher 10a mit sinkendem Energiepegel bis auf den momentanen Energiepegel des zweiten Energiespeichers 10b. Um eine Unterdrückung von Mitkopplungserscheinungen des elektronischen Schalters 30 und/oder eine Verriegelung von durch den elektronischen Schalter 30, vom ersten Energiespeicher 10a zum zweiten Energiespeicher 10b fließenden Energierückströmen zu erreichen, weist die Steuerungsschaltung 50 wenigstens eine Entkopplungsschaltung 20 auf.

Ein konventioneller Hochsetzsteller besitzt eine Diode in Sperrrichtung zum Ausgang. Zur Erhöhung des Wirkungsgrades und zum Schutz vor thermischer Überlastung, wird statt der Diode ein Transistor als Schalter 30 verwendet, der als MOSFET z.B. als OR-MOS-Implementation ausgebildet ist. Dessen herstellungsbedingt immer vorhandene interne parasitäre Diode soll, bei vorwärts fließendem Strom, durch den Schalter 30 unterstützend überbrückt werden. Im Sperrfall soll aber nur dessen parasitäre Diode wirken.

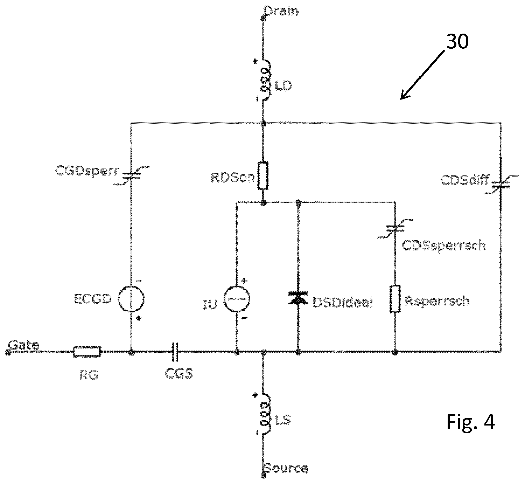

Der Einsatz des Schalters 30, also des Transistors wie eines MOSFETs, hat jedoch den Nachteil, dass dieser - im Gegensatz zu einer Diode - bidirektional leitfähig ist. D.h. für den Hochsetzvorgang ist eine entsprechende Entkopplungsschaltung 20 erforderlich, da nach jedem Schaltvorgang die hochgesetzte Spannung sich durch den fließenden Rückwärtsstrom vom höheren Potential des ersten Energiespeichers 10a zum niedrigeren Potential des zweiten Energiespeichers 10b sofort wieder abbaut. Dabei muss ggf. auch den Mitkopplungserscheinungen des elektronischen Schalters 30 Rechnung getragen werden, worauf unten in Zusammenhang mit Fig. 4 noch näher eingegangen wird.

Im Hinblick auf die Energiespeicher gibt es keine Einschränkungen. Es ist möglich, die Eigenschaften wenigstens zweier beliebiger Energiespeicher 10a, 10b miteinander zu kombinieren. Zum Beispiel ist ein Energiespeicher mit niedriger Impedanz kombinierbar mit einem Energiespeicher höherer Impedanz. Beispielsweise wäre es denkbar, als ersten Energiespeicher 10a und zweiten Energiespeicher 10b jeweils Batterien mit unterschiedlichen Impedanzen zu verwenden. Ebenfalls denkbar ist aber auch eine Verwendung wenigstens eines Kondensators, z.B. eines Doppelschichtkondensators als Energiespeicher, beispielsweise als ersten Energiespeicher 10a.

In einem bevorzugten Ausführungsbeispiel ist der elektronische Schalter 30 als ein Transistor ausgeführt, als ein MOS z.B. in einer OR-MOS-Implementation.

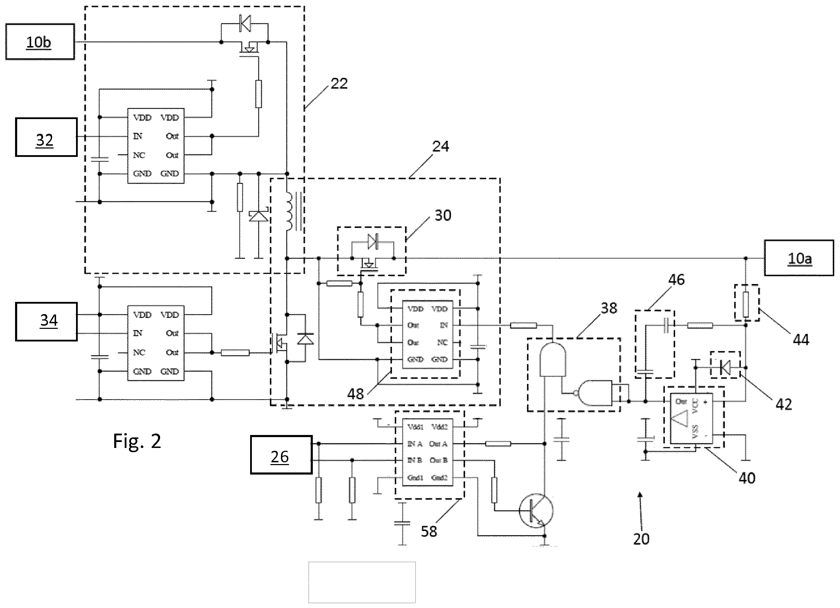

Vorzugsweise weist der erste Energiespeicher 10a wenigstens den gleichen nominalen Energiepegel, beispielsweise die gleiche Nominalspannung und/oder den gleichen Nominalstrom wie der zweite Energiespeicher 10b auf. Die Entkopplungsschaltung 20 weist bevorzugt wenigstens eine digitale Entkopplungsschaltung und/oder analoge Entkopplungsschaltung gemäß Fig. 2 auf.

In Figur 2 ist ein Ausschnitt des hybriden Energiespeichersystems 100 als ein elektronischer Schaltplan dargestellt. In einem weiteren bevorzugten Ausführungsbeispiel weist die analoge Entkopplungsschaltung 20 eine Begrenzer 42, einen Komparator 40, und wenigstens eines der folgenden Elemente auf: wenigstens ein Proportionalglied 44, und/oder wenigstens ein Integrierglied 46.

Das Proportionalglied 44 ist bevorzugt als wenigstens ein Widerstand ausgeführt, der den Strom in den Komparator 40 begrenzt. Prinzipiell denkbar sind auch andere Strombegrenzer. Bevorzugt weist das Integrierglied 46 wenigstens einen Kondensator auf, der Mittkopplungserscheinungen des Schalters 30 unterdrückt.

Für eine Abschaltung des Schalters 30 bei ausgeschaltetem Hochsetzsteller 24 weist die Entkopplungsschaltung 20 wenigstens ein UND-Gatter 38 auf, beispielsweise durch eine logische "0" am UND-Gatter 38.

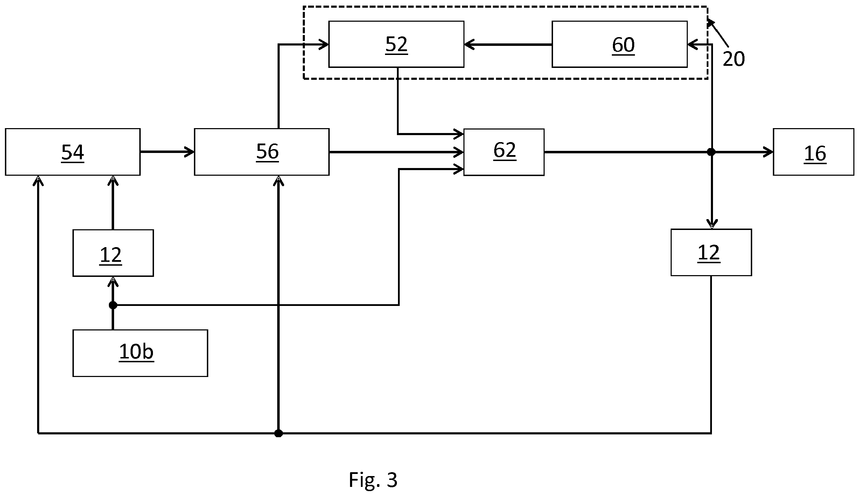

Für eine Regelung von Energieströmen, beispielsweise von Strömen und/oder Spannungen, müssen Messwerte von den Energiespeichern 10a, 10b und/oder der Energiequelle und/oder Energiesenke 16 bekannt sein. Daher weist die Steuerungsschaltung 50 in einem weiteren bevorzugten Ausführungsbeispiel wenigstens eine entsprechende Messwerterfassung 12 (Fig. 3) auf, die der Übersichtlichkeit halber in Fig. 2 weggelassen wurde.

In einem weiteren bevorzugten Ausführungsbeispiel in Figur 3 ist ein Ausschnitt des hybriden Energiespeichersystems 100 mit einer Regeleinrichtung 56, welche wenigstens einen Hochsetzsteller 24 und wenigstens einen Tiefsetzsteller 22 aufweist, schematisch dargestellt. Die Messwerterfassung 12 erfasst Messwerte, beispielsweise Spannung und/oder Strom, der Energiesenke 16 und der Energiespeicher 10a, 10b. Die Messwerte bestimmen den jeweiligen Betriebsmodus des hybriden Energiespeichersystems 100, z.B. einen Tiefsetzsteller- oder einen Hochsetzstellerbetrieb, sowie Führungsgrößen für ein Lademanagement 54, welches wenigstens einen Mikrokontroller 26 aufweist. Die Führungsgrößen sind beispielsweise Strom und Spannung der externen Energiesenke 16 und sind beliebig mit Hilfe des Lademanagements 54 parametrisierbar und dienen dazu, die wenigstens zwei Energiespeicher 10a, 10b in ihrem Komfortbereich zu betreiben. Wird beispielsweise ein vorher definierter Strom überschritten, so dient der Energiespeicher 10a, welcher beispielsweise als ein niederimpedanter Doppelschichtkondensator ausgeführt ist, als Strom-und Spannungsquelle. Hat die Spannung des niederimpedanten Energiespeichers 10a beim Entladen den Spannungswert des anderen Energiespeichers 10b, beispielsweise einer Batterie, erreicht, ergeben sich zwei Betriebszustände. Soll weiterhin Strom fließen, wird durch ein Stellglied 62, welches wenigstens einen Schalter 30 aufweist, der Energiespeicher 10b mit der Energiesenke 16 z.B. einem Verbraucher verbunden. Soll kein Strom mehr fließen, wird die Betriebspause zum Wiederaufladen des Energiespeichers 10a verwendet.

Das Stellglied 62 arbeitet mit Hilfe unterschiedlicher Eingangssignale. Mit dem Ausgangssignal der Regeleinrichtung 56; mit einem Signal, beispielsweise der Spannung des Energiespeichers 10b, die das Stellglied 62 vom Tiefsetzsteller- in den Hochsetzstellerbetrieb und umgekehrt steuert; mit einem Verriegelungssignal eines Verriegelungssignalgebers 52 eines Stromrichtungsdiskriminators 60 zur Verhinderung des Energierückwärtsstroms, wobei die Entkopplungsschaltung 20 wenigstens den Verriegelungssignalgeber 52 und den Stromrichtungsdiskriminator 60 umfasst. Der Stromrichtungsdiskriminator 60 umfasst wenigstens einen Schwellwertschalter mit wenigstens einer Hysteresefunktion und/oder wenigstens einer Übertragungsfunktion wenigstens erster Ordnung, z.B. f(s) = K/(Ts+1), wobei s den Laplace-Operator, K einen statischen Übertragungsfaktor und T eine Zeitkonstante beschreibt.

Der Energiespeicher 10b ist in diesem Ausführungsbeispiel beispielsweise als eine Batterie ausgeführt und hat typischerweise eine höhere Impedanz wie der Energiespeicher 10a, welcher beispielsweise als ein Kondensator, z.B. als ein Doppelschichtkondensator ausgeführt ist. Denkbar sind aber auch zwei Energiespeicher 10a, 10b, z.B. zwei Batterien, eine Batterie mit hoher Impedanz und eine Batterie mit niedrigerer Impedanz. Anstatt einer Batterie mit niedrigerer Impedanz ist auch ein Kondensator, z.B. ein Doppelschichtkondensator denkbar.

Prinzipiell kann der Stromrichtungsdiskriminator 60 auch digital ausgeführt werden, beispielsweise in der Regeleinrichtung 56. Eine Verriegelung des Rückwärtsstroms wäre z.B. über eine Messung denkbar, die die Stromanstiegsgeschwindigkeit einem definierten Stromschwellwert bzw. einem Spannungsschwellwert zwischen Hochsetz- 24 und Tiefsetzsteller 22 mit extrem schnellen Analog/Digital Wandlern misst und entweder im Mikrocontroller 26 integriert ist oder extern als integrierter Schaltkreis verbunden ist. Die Analog/Digital Wandler verarbeiten die Signale der Messwerterfassung 12, die ebenfalls eine Dynamik und Messgeschwindigkeit von wenigen Nanosekunden aufweisen.

Zur Steuerung wenigstens eines elektrophysikalischen Energiestroms zwischen den wenigstens zwei Energiespeichern, die einen ersten Energiespeicher 10a und einem zweiten Energiespeicher 10b mit jeweils einem nominalen Energiestrom und/oder wenigstens einer externen Energiequelle und/oder wenigstens einer externen Energiesenke 16 umfassen, ist wenigstens einer Steuerungsschaltung 50 mit wenigstens einem Hochsetzsteller 24, der wenigstens einen elektronischen Schalter 30 aufweist, und/oder Tiefsetzsteller 22 vorgesehen. Die Energiesenke 16 wird im Falle eines benötigten Energiestroms, der höher als der nominale Energiestrom des zweiten Energiespeichers 10b ist, mit einem Energiestrom des ersten Energiespeichers 10a bedient, während der zweite Energiespeicher 10b einen Energiestrom von null oder einen konstanten Energiestrom liefert, der maximal dem nominalen Energiestrom des zweiten Energiespeichers 10b entspricht. Mitkopplungserscheinungen des elektronischen Schalters 30 und/oder durch den elektronischen Schalter 30, vom ersten Energiespeicher 10a zum zweiten Energiespeicher 10b fließende Energierückströme werden unterdrückt.

Mitkopplungserscheinungen sind vor allem hochfrequente Schaltvorgänge, die bis zur Zerstörung der Entkopplungsschaltung 20 wie z.B. zur Zerstörung des hierzu beispielhaft verwendeten Transistors wie z.B. eines OR-MOSFET führen können. Ein Transistor wie z.B. ein MOSFET oder "OR-MOS" als Schalter 30 ist kein ideales Bauelement und hat, wie jedes andere Bauelement auch, parasitäre Eigenschaften. Mit Hilfe einer Modellbeschreibung eines MOSFET als Schalter 30 gemäß Fig. 4 ergibt sich als Hauptursache dafür die je nach Schaltvorgang bestehende Sperrschichtkapazität der parasitären Diode (DSDideal) oder die differentielle Drain-Source-Kapazität (CDSdiff) des Transistors. Diese Kapazität bildet im Zusammenhang des Freilaufstromes der Hochsetzsteller-Induktivität eine Resonanz. Die Sperrschicht baut sich bei Beginn der Durchlassphase langsam ab und in der Sperrphase auf. Dieser Vorgang geschieht, besonders bei geringen Durchlassströmen, nicht abrupt. Der in Durchlassrichtung zur parasitären Kapazität befindliche parasitäre Parallelwiderstand RDSon des Schalters 30 verursacht einen Spannungsabfall, welcher wiederum Einfluss auf die Entkopplungsschaltung 20 hat. D.h. zusätzlich zum Gleichstrom durch den Schalter 30 kommt ein überlagerter Wechselstromanteil der oben genannten Resonanzursache hinzu. Da die überlagerten negativen Halbwellen der Resonanzamplitude, bei niedrigem Gleichstromanteil, der Entkopplungsschaltung 20 und damit der Steuerschaltung 50 einen scheinbar rückwärts fließenden Strom vorgeben und die positiven Halbwellen der Resonanzamplitude einen zusätzlich vorwärts fließenden Strom vorgeben, beginnt die Ansteuerlogik den Schalter 30 mit der Resonanzfrequenz (meist im MHz Bereich) zu schalten. Diese hochfrequenten Schaltvorgänge, hier Mitkopplungserscheinungen genannt, führen zur Zerstörung des OR-MOS und werden daher mit dem Integrierglied 46 verhindert bzw. ausgekoppelt. In der Kombination ergibt sich eine sehr schnelle Umschaltmöglichkeit zwischen den Energiespeichern 10a, 10b ohne Mitkopplungserscheinungen.

Bei sinkenden Ladeströmen des Energiespeichers 10a verkleinert sich die Einschaltzeit der PWM des Schalters 30 bis zur Unterschreitung der Frequenz der Entkopplungsschaltung 20. Ab diesem Zeitpunkt lässt die Entkopplungsschaltung keine Ströme durch den Schalter 30 mehr in den Energiespeicher 10a zu und es wirkt dann nur noch die interne parasitäre Diode des Schalters 30. Um dennoch eventuell auftretende unnötige Schaltvorgänge der Entkopplungsschaltung zu vermeiden und den Wirkungsgrad in dem Fall zu verbessern, ist es möglich, mit dem Mikrocontroller 26 über den isolierten Datenkoppler 58 die Entkopplungsschaltung außer Betrieb zu nehmen.

Es versteht sich von selbst, dass diese Beschreibung verschiedensten Modifikationen, Änderungen und Anpassungen unterworfen werden kann, die sich im Bereich den anhängenden Ansprüchen bewegen.

### Bezugszeichenliste

- 10a: erster Energiespeicher
- 10b: zweiter Energiespeicher
- 12: Messwerterfassung
- 14: Brückenschalter
- 16: Energiesenke
- 20: Entkopplungsschaltung
- 22: Tiefsetzsteller
- 24: Hochsetzsteller
- 26: Mikrocontroller
- 28: Digital/Analog Wandler
- 30: Schalter
- 32: Pulsweitenmodulator Tiefsetzsteller
- 34: Pulsweitenmodulator Hochsetzsteller
- 36: Kontrollschalter
- 38: UND-Gatter
- 40: Komparator
- 42: Begrenzer
- 44: Proportionalglied
- 46: Integrierglied
- 48: Gate-Treiber
- 50: Steuerungsschaltung
- 52: Verriegelungssignalgeber
- 54: Lademanagement
- 56: Regeleinrichtung
- 58: isolierter Datenkoppler
- 60: Stromrichtungsdiskriminator
- 62: Stellglied
- 100: Hybrides Energiespeichersystem

## Patentansprüche

1. Hybrides Energiespeichersystem, umfassend
- wenigstens zwei Energiespeicher, umfassend einen ersten Energiespeicher (10a) und einen zweiten Energiespeicher (10b) mit jeweils einem nominalen Energiestrom,
- wenigstens einen Hochsetzsteller (24), der wenigstens einen elektronischen Schalter (30) aufweist,
- wenigstens einen Tiefsetzsteller (22),
- einer Steuerungsschaltung (50), mit deren Hilfe die Energiespeicher (10a, 10b) untereinander und mit wenigstens einer externen Energiesenke (16) und ggf. wenigstens einer externen Energiequelle elektrische Energie mittels elektrophysikalischer Energieströme wenigstens in einer Richtung austauschen,
- wobei die Steuerungsschaltung (50) einen Mikrocontroller (26) aufweist und mit Hilfe des wenigstens einen Hochsetzstellers (24) und des wenigstens einen Tiefsetzstellers (22) die Energiesenke (16) im Falle eines benötigten Energiestroms der Energiesenke (16), der höher als der nominale Energiestrom des zweiten Energiespeichers (10b) ist, mit einem Energiestrom des ersten Energiespeichers (10a) bedient, während der zweite Energiespeicher (10b) einen Energiestrom von null oder einen konstanten Energiestrom liefert, der maximal dem nominalen Energiestrom des zweiten Energiespeichers (10b) entspricht,
- wobei die Steuerungsschaltung (50) wenigstens eine Entkopplungsschaltung (20) zur Unterdrückung von Mitkopplungserscheinungen des elektronischen Schalters (30) und zur Verriegelung von durch den elektronischen Schalter (30) vom ersten Energiespeicher (10a) zum zweiten Energiespeicher (10b) fließenden Energierückströmen aufweist, wobei der elektronische Schalter (30) wenigstens einen MOSFET-Transistor aufweist,
- wobei die Entkopplungsschaltung eine analoge Schaltung ist, und wenigstens einen Begrenzer (42), wenigstens einen Komparator (40), wobei der Begrenzer (42) am Eingang des Komparators (40) angeordnet ist und dessen Spannung begrenzt, sowie wenigstens ein UND-Gatter (38) zur Abschaltung des elektronischen Schalters (30) bei ausgeschaltetem Hochsetzsteller (24) aufweist, wobei der Begrenzer (42), der Komparator (40) und das UND-Gatter (38) hintereinander geschaltet sind, wobei eine Unterdrückung der Mitkopplungserscheinungen und eine Verriegelung von Energierückströmen vom ersten Energiespeicher (10a) zum zweiten Energiespeicher (10b) erfolgt,
- wobei der Mikrocontroller (26) über einen unterschiedliche Potentiale der Energiespeicher (10a, 10b) isolierend verbindenden Datenkoppler (58) mit der Entkopplungsschaltung (20) verbunden ist, um die Entkopplungsschaltung (20) außer Betrieb zu nehmen.

2. Hybrides Energiespeichersystem nach Anspruch 1, **dadurch gekennzeichnet, dass** der erste Energiespeicher (10a) wenigstens die gleiche Nominalspannung wie der zweite Energiespeicher (10b) aufweist.

3. Hybrides Energiespeichersystem nach Anspruch 1, **dadurch gekennzeichnet, dass** der erste Energiespeicher (10a) wenigstens den gleichen Nominalstrom wie der zweite Energiespeicher (10b) aufweist

4. Hybrides Energiespeichersystem nach Anspruch 1, **dadurch gekennzeichnet, dass** die analoge Entkopplungsschaltung wenigstens eines der folgenden Elemente aufweist umfassend wenigstens ein Proportionalglied (44) und wenigstens ein Integrierglied (46).

5. Hybrides Energiespeichersystem nach Anspruch 4, **dadurch gekennzeichnet, dass** das Proportionalglied (44) wenigstens einen Widerstand aufweist, der den Strom in den Komparator (40) begrenzt.

6. Hybrides Energiespeichersystem nach Anspruch 5, **dadurch gekennzeichnet, dass** das Integrierglied (46) wenigstens einen Kondensator aufweist, der Mittkopplungserscheinungen des Schalters (30) unterdrückt.

7. Hybrides Energiespeichersystem nach einem der vorhergehenden Ansprüche, **dadurch gekennzeichnet, dass** die Steuerungsschaltung (50) wenigstens eine Messwerterfassung (12) zur Erfassung von Messwerten wenigstens eines der Elemente umfassend die Energiespeicher (10a, 10b), die Energiequelle, die Energiesenke (16) aufweist.

8. Verfahren zur Steuerung wenigstens eines elektrophysikalischen Energiestroms wenigstens in einer Richtung zwischen wenigstens zwei Energiespeichern, umfassend einen ersten Energiespeicher (10a) und einen zweiten Energiespeicher (10b) mit jeweils einem nominalen Energiestrom und wenigsten einer externen Energiesenke (16) und ggf. wenigstens einer externen Energiequelle,
mit einer Steuerungsschaltung (50) mit einem Mikrocontroller (26) und mit wenigstens einem Hochsetzsteller (24), der wenigstens einen elektronischen Schalter (30) aufweist, und wenigstens einem Tiefsetzsteller (22), wobei die Energiesenke (16) im Falle eines benötigten Energiestroms, der höher als der nominale Energiestrom des zweiten Energiespeichers (10b) ist, mit einem Energiestrom des ersten Energiespeichers (10a) bedient wird, während der zweite Energiespeicher (10b) einen Energiestrom von null oder einen konstanten Energiestrom liefert, der maximal dem nominalen Energiestrom des zweiten Energiespeichers (10b) entspricht,
wobei als elektronischer Schalter (30) ein MOSFET-Transistor verwendet wird, dessen Mitkopplungserscheinungen unterdrückt werden,
wobei durch den MOSFET-Transistor vom ersten zum zweiten Energiespeicher (10a, 10b) fließende Energierückströme unterdrückt werden,
wobei eine analoge Entkopplungsschaltung mit wenigstens einem Begrenzer (42), wenigstens einem Komparator (40), wobei der Begrenzer (42) am Eingang des Komparators (40) angeordnet ist und dessen Spannung begrenzt, sowie wenigstens einem UND-Gatter (38) verwendet wird, wobei der Begrenzer (42), der Komparator (40) und das UND-Gatter (38) hintereinander geschaltet werden,
wobei das UND-Gatter den elektronischen Schalter (30) bei ausgeschaltetem Hochsetzsteller (24) abschaltet, sodass eine Unterdrückung der Mitkopplungserscheinungen und eine Verriegelung von Energierückströmen vom ersten Energiespeicher (10a) zum zweiten Energiespeicher (10b) erfolgt, und
wobei der Mikrocontroller (26) über einen unterschiedliche Potentiale der Energiespeicher (10a, 10b) isolierend verbindenden Datenkoppler (58) mit der Entkopplungsschaltung (20) verbunden ist, um die Entkopplungsschaltung (20) außer Betrieb zu nehmen.

## Claims

1. A hybrid energy storage system, including:
- at least two energy storage units, comprising a first energy storage unit (10a) and a second energy storage unit (10b), each with a nominal energy flow,
- at least one boost converter (24) comprising at least one electronic switch (30),
- at least one buck converter (22),
- at least one control circuit (50), by means of which the energy storage units (10a, 10b) exchange electrical energy with one another and with at least one external energy sink (16) and, if necessary, with at least one external energy source, by means of electrophysical energy flows in at least one direction,
- wherein, by means of the at least one boost converter (24) and by means of the at least one buck converter (22), the control circuit (50) comprising a microcontroller (26) provides an energy flow from the first energy storage unit (10a) to the energy sink (16) in the event that the energy sink (16) requires a higher energy flow than the nominal energy flow from the second energy storage unit (10b), while the second energy storage unit (10b) supplies an energy flow of zero or a constant energy flow corresponding at most to the nominal energy flow of the second energy storage unit (10b),
- wherein the control circuit (50) comprises at least one decoupling circuit (20) for suppressing positive feedback phenomena in the electronic switch (30) and for blocking reversed energy flows through the electronic switch (30) from the first energy storage unit (10a) to the second energy storage unit (10b), wherein the electronic switch (30) comprises at least one MOSFET transistor,
- wherein the decoupling circuit is an analogue circuit and comprises at least one limiter (42), at least one comparator (40), wherein the limiter is arranged at the input of the comparator (40) and limits the voltage thereof, and at least one AND gate (38) for switching off the electronic switch (30) when the boost converter (24) is switched off, wherein the limiter (42), the comparator (40) and the AND gate (38) are connected in series, with suppression of the positive feedback phenomena and interlocking of reversed energy flows from the first energy storage unit (10a) to the second energy storage unit (10b),
- wherein the microcontroller (26) is connected to said decoupling circuit (20) via a data coupler (58) isolating different potentials of the energy storage units (10a, 10b) to disengage the decoupling circuit (20).

2. A hybrid energy storage system according to Claim 1, **characterised in that** the first energy storage unit (10a) comprises at least the same nominal voltage as the second energy storage unit (10b).

3. A hybrid energy storage system according to Claim 1, **characterised in that** the first energy storage unit (10a) comprises at least the same nominal current as the second energy storage unit (10b).

4. A hybrid energy storage system according to Claim 1, **characterised in that** the analogue decoupling circuit comprises at least one of the following elements including at least one proportional element (44) and at least one integrating element (46).

5. A hybrid energy storage system according to Claim 4, **characterised in that** the proportional element (44) comprises at least one resistor that limits the current to the comparator (40).

6. A hybrid energy storage system according to Claim 4, **characterised in that** the integrating element (46) comprises at least one capacitor that suppresses positive feedback phenomena in the switch (30).

7. A hybrid energy storage system according to one of the preceding claims, **characterised in that** the control circuit (50) comprises at least one measured value detector (12) for detecting measured values of at least one of the elements including the energy storage units (10a, 10b), the energy source, the energy sink (16).

8. A method for controlling at least one electrophysical energy flow in at least one direction between at least two energy storage units, comprising a first energy storage unit (10a) and a second energy storage unit (10b), each with a nominal energy flow, and at least one external energy sink (16) and, if necessary, at least one external energy source, comprising at least one control circuit (50) having a microcontroller (26) and at least one boost converter (24) comprising at least one electronic switch (30), and at least one buck converter (22), wherein, in the event that the energy sink (16) requires a higher energy flow than the nominal energy flow from the second energy storage unit (10b), the energy sink (16) is provided with an energy flow from the first energy storage unit (10a), while the second energy storage unit (10b) supplies an energy flow of zero or a constant energy flow corresponding at most to the nominal energy flow of the second energy storage unit (10b),
wherein a MOSFET transistor is used as the electronic switch (30), wherein positive feedback phenomena of the MOSFET transistor are suppressed,
wherein reversed energy flows through the MOSFET transistor from the first to the second energy storage unit (10a, 10b) are suppressed,
wherein an analogue decoupling circuit comprising at least one limiter (42), at least one comparator (40), wherein the limiter is arranged at the input of the comparator (40) and limits the voltage thereof, and at least one AND gate (38) is used, wherein the limiter (42), the comparator (40) and the AND gate (38) are connected in series, wherein the AND gate (38) switches off the electronic switch (30) when the boost converter (24) is switched off, so that a suppression of the positive feedback phenomena and a locking of reversed energy flows from the first energy storage unit (10a) to the second energy storage unit (10b) occurs, and
wherein the microcontroller (26) is connected to said decoupling circuit (20) via a data coupler (58) isolating different potentials of the energy storage units (10a, 10b) to disengage the decoupling circuit (20).

## Revendications

1. Système de stockage d'énergie hybride, comprenant :
- au moins deux accumulateurs d'énergie, comprenant un premier accumulateur d'énergie (10a) et un deuxième accumulateur d'énergie (10b) ayant chacun un flux d'énergie nominal,
- au moins un convertisseur élévateur (24) qui comporte au moins un interrupteur électronique (30),
- au moins un convertisseur abaisseur (22),
- un circuit de commande (50), à l'aide duquel les accumulateurs d'énergie (10a, 10b) échangent entre eux et avec au moins un puits d'énergie externe (16) et éventuellement avec au moins une source d'énergie externe de l'énergie électrique au moyen de flux d'énergie électro-physiques au moins dans une direction,
- dans lequel le circuit de commande (50) comporte un microcontrôleur (26) et, à l'aide du ou des convertisseur(s) élévateur(s) (24) et du ou des convertisseur(s) abaisseur (22), alimente le puits d'énergie (16), en cas de besoin d'un flux d'énergie du puits d'énergie (16) supérieur au flux d'énergie nominal du deuxième accumulateur d'énergie (10b), avec un flux d'énergie du premier accumulateur d'énergie (10a), pendant que le deuxième accumulateur (10b) fournit un flux d'énergie de zéro ou un flux d'énergie constant qui correspond au maximum au flux d'énergie nominal du deuxième accumulateur d'énergie (10b),
- dans lequel le circuit de commande (50) comporte au moins un circuit de découplage (20) pour l'empêchement de phénomènes de réaction positive de l'interrupteur électronique (30) et pour le verrouillage des flux d'énergie inverses circulant à travers l'interrupteur électronique (30), du premier accumulateur d'énergie (10a) au deuxième accumulateur d'énergie (10b), l'interrupteur électronique (30) comportant au moins un transistor MOSFET,
- dans lequel le circuit de découplage est un circuit analogique, et comporte au moins un limiteur (42), au moins un comparateur (40), le limiteur (42) étant disposé à l'entrée du comparateur (40) et limitant sa tension, ainsi qu'au moins une porte ET (38) pour la déconnexion de l'interrupteur électronique (30) lorsque le convertisseur élévateur (24) est déconnecté, le limiteur (42), le comparateur (40) et la porte ET (38) étant connectés en série, un empêchement de phénomènes de réaction positive et un verrouillage des flux d'énergie inverses du premier accumulateur d'énergie (10a) au deuxième accumulateur d'énergie (10b) se produisant,
- dans lequel le microcontrôleur (26) est relié par l'intermédiaire d'un coupleur de données (58) reliant de façon isolée des potentiels différents des accumulateurs d'énergie (10a, 10b), avec le circuit de découplage (20), afin de mettre le circuit de découplage (20) hors circuit.

2. Système de stockage d'énergie hybride selon la revendication 1, **caractérisé en ce que** le premier accumulateur d'énergie (10a) comporte au moins la même tension nominale que le deuxième accumulateur d'énergie (10b).

3. Système de stockage d'énergie hybride selon la revendication 1, **caractérisé en ce que** le premier accumulateur d'énergie (10a) comporte au moins le même courant nominal que le deuxième accumulateur d'énergie (10b).

4. Système de stockage d'énergie hybride selon la revendication 1, **caractérisé en ce que** le circuit de découplage analogique comprend au moins l'un des éléments suivants : au moins un élément à action proportionnelle (44) et au moins un élément à action intégrale (46).

5. Système de stockage d'énergie hybride selon la revendication 4, **caractérisé en ce que** l'élément à action proportionnelle (44) comporte au moins une résistance, qui limite le courant dans le comparateur (40).

6. Système de stockage d'énergie selon la revendication 5, **caractérisé en ce que** l'élément à action intégrale (46) comprend au moins un condensateur qui empêche les phénomènes de réaction positive de l'interrupteur (30).

7. Système de stockage d'énergie hybride selon l'une des revendications précédentes, **caractérisé en ce que** le circuit de commande (50) comprend au moins une acquisition de valeurs de mesure (12) pour acquérir les valeurs de mesure d'au moins l'un des éléments suivants : les accumulateurs d'énergie (10a, 10b), la source d'énergie, le puits d'énergie (16).

8. Procédé pour la commande d'au moins un flux d'énergie électro-physique dans au moins une direction entre au moins deux accumulateurs d'énergie, comprenant un premier accumulateur d'énergie (10a) et un deuxième accumulateur d'énergie (10b) ayant chacun un flux d'énergie nominal et au moins un puits d'énergie externe (16) et éventuellement au moins une source d'énergie externe, comportant un circuit de commande (50) avec un microcontrôleur (26) et au moins un convertisseur élévateur (24), lequel comporte au moins un interrupteur électronique (30), et au moins un convertisseur abaisseur (22), dans lequel le puits d'énergie (16), en cas de besoin d'un flux d'énergie supérieur au flux d'énergie nominal du deuxième accumulateur (10b), est alimenté avec un flux d'énergie du premier accumulateur d'énergie (10a), pendant que le deuxième accumulateur d'énergie (10b) fournit un flux d'énergie de zéro ou un flux d'énergie constant, qui correspond au maximum au flux d'énergie nominal du deuxième accumulateur d'énergie (10b),
dans lequel, en tant qu'interrupteur électronique (30), un transistor MOSFET est utilisé, dont les phénomènes de réaction positive sont empêchés,
dans lequel, grâce au transistor MOFSET des flux d'énergie inverses circulant du premier au deuxième accumulateur d'énergie (10a, 10b) sont empêchés,
dans lequel est utilisé un circuit de découplage analogique ayant au moins un limiteur (42), au moins un comparateur (40), le limiteur (42) étant disposé à l'entrée du comparateur (40) et limitant la tension de ce dernier, ainsi qu'au moins une porte ET (38), le limiteur (42), le comparateur (40) et la porte ET (38) étant connectés en série,
dans lequel la porte ET déconnecte l'interrupteur électronique (30) lorsque le convertisseur élévateur (24) est déconnecté, de telle sorte qu'il se produise un empêchement des phénomènes de réaction positive et un verrouillage des flux d'énergie inverses du premier accumulateur d'énergie (10a) au deuxième accumulateur d'énergie (10b), et
dans lequel le microcontrôleur (26) est relié, par l'intermédiaire d'un coupleur de données reliant de façon isolée des potentiels différents des accumulateurs d'énergie (10a, 10b), au circuit de découplage (20), afin de mettre le circuit de découplage (20) hors circuit.
